# NEW EUROPEAN PATENT SPECIFICATION

(11) **EP 1 336 069 B2**
(45) Date of publication and mention of the opposition decision: **04.05.2011**
(45) Mention of the grant of the patent: 17.08.2005
(21) Application number: 01945825.6
(22) Date of filing: 26.06.2001
(51) Int. Cl.: F24D 3/14, C23C 14/20

(54) **PLASTIC PIPE WITH A BARRIER LAGER**
KUNSTSTOFFROHR MIT SPERRSCHICHT
TUYAU EN PLASTIQUE A COUCHE BARRIERE

(30) Priority: 27.06.2000 NL 1015537
(43) Date of publication of application: 20.08.2003
(73) Proprietor: Nederlandse Organisatie voor Toegepast -Natuurwetenschappelijk Onderzoek TNO, 2628 VK Delft (NL)
(72) Inventor: NEGRI, Nicola, Giuseppe, NL-7731 AM Ommen (NL); GONS, Johan, NL-7701 PS Dedemsvaart (NL)
(74) Representative: Prins, Adrianus Willem
(86) International application number: PCT/NL2001/000473
(87) International publication number: WO 2002/001115

(56) References cited:
- EP-B1- 0 635 582
- DE-A- 3 320 273
- DE-U- 29 607 324
- DE-U- 29 822 212
- JP-A- 09 117 978
- US-A- 3 567 487
- US-A- 4 131 530
- US-A- 5 685 961
- US-B1- 6 355 304
- VACUUM DEPOSITION OF THIN FILMS, L. HOLLAND 1956

## Description

The invention relates to a plastic pipe with a barrier layer applied to its outer side.

Plastic pipes as such are not completely impermeable to all media in all situations. In particular, pipes made from polyolefins, such as polyethylene and polypropylene, to a certain extent allow substances such as oxygen and certain organic substances to pass through. This may cause problems. When using plastic pipes for indoor heating purposes, oxygen may diffuse inwards through the pipe wall and may then affect the metal components of the heating system. When using plastic pipes as outdoor water pipes in ground which is contaminated with organic substances, these substances may have an adverse effect on the quality of the water in the pipe.

Therefore, it is proposed for the plastic pipes for such applications to be provided with a barrier layer, in particular a layer of metal, which is completely resistant to diffusion, on the outer side.

Known methods for applying the layer of metal are, for example, winding a metal foil around the plastic pipe or forming a thin-walled metal pipe and applying a layer of plastic to the inner side and/or the outer side by extrusion. However, the thickness of the layer of metal applied in this way is much greater than is necessary for a good barrier action.

It is known from DE-U-298 22 212 to apply a thin barrier layer of silicon oxide with a thickness of a few nm to µm to a plastic pipe by means of physical deposition under high vacuum. However, it has been found that pipes of this type have an inadequate barrier action.

It is an object of the invention to provide an improved plastic pipe with a barrier layer applied to the outer side.

According to the invention, this object is achieved by means of a plastic pipe according to claim 1.

Tests have shown that the barrier layer is not completely impervious when the outer surface of the plastic pipe is in its usual state and has the usual roughness. Although when looked at normally the outer surface appears to be smooth, on a microscale there is nevertheless considerable unevenness which, when a very thin layer of metal is being applied, as is the case here, leads to interruptions in the barrier layer, with the result that the barrier layer is not completely impermeable.

The plastic pipe according to the invention has the desired barrier action with a minimal thickness of the barrier layer.

The invention also relates to a method for the manufacture of a plastic pipe according to claim 11.

This method enables a very thin diffusion-resistant metal layer to be applied to a plastic pipe.

Preferred embodiments of the plastic pipe and the method according to the invention are defined in the dependent claims.

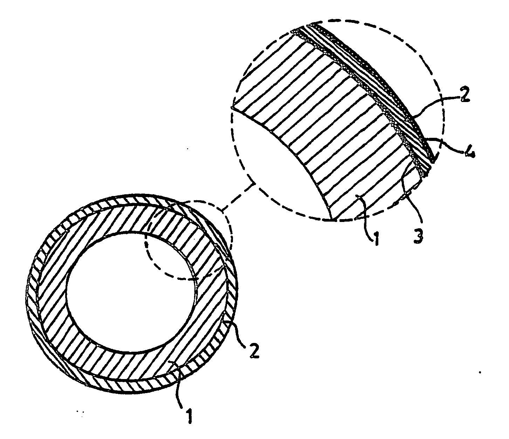

The invention will be explained in more detail with reference to the drawing, in which the only figure shows a cross section through a plastic pipe according to the invention.

The drawing shows a cross section through a plastic pipe 1 which is provided on its outer side with a thin barrier layer, such as a layer of metal 2. A plastic pipe of this type is used, for example, indoors in heating installations or outdoors as a water pipe in ground which is contaminated with organic substances. The layer of metal provides the plastic pipe with the desired barrier properties.

The plastic pipe 1 is manufactured, for example, from a polyolefin, such as polyethylene, polypropylene or polybutylene.

According to the invention, the barrier layer 2 is less than 1 µm, preferably less than 0.1 µm, thick and preferably consists of aluminium, an aluminium alloy or aluminium oxide. As an alternative to aluminium, it is also possible to consider other metals, such as copper and zinc. If appropriate, it would also be possible to use other materials, such as silicon oxide.

In the text which follows, it will be assumed that a layer of metal is used as the barrier layer.

The layer of metal 2 is applied to the plastic pipe 1 by physical vapour deposition under high vacuum, a technique which is known per se.

To achieve good adhesion between the very thin metal layer 2 and the plastic pipe 1 and/or a diffusion-resistant layer 2, the outer surface of the plastic pipe 1 is smoothed prior to the physical vapour deposition. The smoothing is preferably effected by the application of a layer of lacquer, by extrusion or by spraying. The thickness of the layer of lacquer is preferably 10 µm.

On the outer side, the metal layer is preferably provided with a protective layer 4, which may consist of the same material as the plastic pipe 1. This protective layer 4 is used in particular to prevent mechanical damage to the very thin layer of metal 2, but also to prevent excess oxidation of this layer. The protective layer may also be provided with certain additives, such as dyes or UV shields, or may be printed. This allows the plastic pipe to be made more suitable for a specific purpose.

The protective layer on the outer side may also consist of a layer of lacquer which is similar to or of the same type as the layer of lacquer between pipe and layer of metal. It has been found that the thin external layer of lacquer also improves the barrier action by preventing mechanical damage to the layer of metal.

A combination of firstly a layer of lacquer and then a layer of plastic provides even better results.

The layer of metal may be applied to the plastic pipe 1 either continuously or discontinuously.

In the continuous method of application, the plastic pipe 1 is successively extruded, smoothed on the outer side, brought to the required high vacuum in a number of steps in successive vacuum chambers with a continuously increasing vacuum, and provided with a layer of metal 2, such as a layer of aluminium, by physical vapour deposition under high vacuum. In the same process, a protective layer 4 is also applied to the outer side of the layer of metal 2 by means of in-line extrusion.

If, as appears possible, the linear speed of the equipment for the physical vapour deposition of the layer of metal is higher than that of the production machines for the pipe, it is obviously also possible for the inherently continuous method to be carried out in separate parts. First of all the pipe is extruded, optionally provided with a smooth outer layer and coiled.

Then, existing coils, if appropriate from a plurality of pipe production machines, can be uncoiled and successively passed through the vapour deposition equipment in a continuous process, optionally after first being provided with a smooth outer layer. This makes it easier to optimally adapt the different capacities to one another.

In the discontinuous application method, the plastic pipe 1 is extruded and provided with a layer of lacquer on the outer side in a continuous process, and a certain length of the pipe 1 formed in this way is coiled, for example on a coiler. Then, the coiled pipe 1 is placed under a high vacuum, is uncoiled, is provided with a layer of metal 2 by physical vapour deposition under high vacuum and is coiled again. In a following step, it is also possible to apply a protective layer 4 to the outer side of the layer of metal 2, which protective layer may comprise a layer of lacquer and/or a layer of plastic.

Although the discontinuous method of application appears time-consuming, it is a simpler design, since the necessary sealing of the successive vacuum chambers through which the plastic pipe 1 provided with a layer of metal 2 has to pass is not easy to achieve without damaging the metal layer 2.

## Claims

1. Plastic pipe with a barrier layer applied to its outer side, the thickness of the barrier,layer being less than 1 µm, **characterised in that** a smooth interlayer is present between the plastic pipe and the barrier layer.

2. Plastic pipe according to claim 1, in which the plastic pipe is manufactured from a thermoplastic.

3. Plastic pipe according to claim 1 or 2, in which the interlayer is a layer of lacquer.

4. Plastic pipe according to one of claims 1-3, in which the barrier layer on the outer side is provided with a protective layer.

5. Plastic pipe according to claim 4, in which the protective layer is a layer of lacquer.

6. Plastic pipe according to claim 4, in which the protective layer is a layer of plastic.

7. Plastic pipe according to claim 4, in which the protective layer comprises, from the inside outwards, a layer of lacquer and a layer of plastic.

8. Plastic pipe according to claim 7 or 8, in which the layer of plastic consists of the same material as the plastic pipe.

9. Plastic pipe according to one of claims 1-8, in which the barrier layer comprises a layer of metal.

10. Plastic pipe according to claim 9, in which the layer of metal consists of aluminium, an aluminium alloy or aluminium oxide.

11. Method for the manufacture of a plastic pipe with a metal layer applied to its outer side, which is applied by physical vapour deposition under high vacuum, the outer side of the plastic pipe being smoothed by the application of a layer of lacquer before the layer of metal is applied, wherein the plastic pipe is a pipe according to claim 1 and said metal layer is the barrier layer and said layer of lacquer is the interlayer.

12. Method according to claim 11, in which the layer of lacquer is applied in a continuous process.

13. Method according to claim 12, in which the layer of lacquer is applied by extrusion.

14. Method according to claim 12, in which the layer of lacquer is applied by spraying.

15. Method according to one of claims 11-14, in which the layer of metal is provided with a protective layer on the outer side.

16. Method according to one of claims 11-15, in which the plastic pipe is successively extruded, smoothed on the outer side, brought to the desired high vacuum in a number of steps in successive vacuum chambers with a continuously increasing vacuum, and provided with a layer of metal by physical vapour deposition under high vacuum.

17. Method according to claim 16, in which, after the layer of metal has been applied, it is provided on the outer side with a protective layer by means of in-line extrusion.

18. Method according to one of claims 11-16, in which the plastic pipe is extruded and is smoothed on the outer side, a certain length of the plastic pipe is coiled, is placed under high vacuum in the coiled state and is uncoiled again, is provided with a layer of metal by physical vapour deposition under high vacuum and is coiled again.

## Patentansprüche

1. Kunststoffrohr mit einer Sperrschicht, die auf seiner Außenseite aufgebracht ist, wobei die Dicke der Sperrschicht geringer als 1 µm ist, **dadurch gekennzeichnet, dass** eine glatte Zwischenschicht zwischen dem Kunststoffrohr und der Sperrschicht vorhanden ist.

2. Kunststoffrohr nach Anspruch 1, bei dem das Kunststoffrohr aus thermoplastischem Material hergestellt ist.

3. Kunststoffrohr nach Anspruch 1 oder 2, bei dem die Zwischenschicht eine Lackschicht ist.

4. Kunststoffrohr nach einem der Ansprüche 1 bis 3, bei dem die Sperrschicht auf der Außenseite mit einer Schutzschicht versehen ist.

5. Kunststoffrohr nach Anspruch 4, bei dem die Schutzschicht eine Lackschicht ist.

6. Kunststoffrohr nach Anspruch 4, bei dem die Schutzschicht eine Kunststoffschicht ist.

7. Kunststoffrohr nach Anspruch 4, bei dem die Schutzschicht, von innen nach außen, eine Lackschicht und eine Kunststoffschicht umfasst.

8. Kunststoffrohr nach Anspruch 7 oder 8, bei dem die Kunststoffschicht aus dem gleichen Material wie das Kunststoffrohr besteht.

9. Kunststoffrohr nach einem der Ansprüche 1 bis 8, bei dem die Sperrschicht eine Metallschicht umfasst.

10. Kunststoffrohr nach Anspruch 9, bei dem die Metallschicht aus Aluminium, einer Aluminiumlegierung oder Aluminiumoxid besteht.

11. Verfahren zur Herstellung eines Kunststoffrohrs mit einer auf seiner Außenseite aufgebrachten Metallschicht, die durch physikalische Dampfablagerung unter Hochvakuum aufgebracht wird, wobei die Außenseite des Kunststoffrohrs durch Aufbringung einer Lackschicht geglättet wird, bevor die Metallschicht aufgebracht wird, wobei das Kunststoffrohr ein Rohr gemäß Anspruch 1 ist und die Metallschicht die Sperrschicht ist und die Lackschicht die Zwischenschicht ist.

12. Verfahren nach Anspruch 11, bei dem die Lackschicht in einem kontinuierlichen Vorgang aufgebracht wird.

13. Verfahren nach Anspruch 12, bei dem die Lackschicht durch Extrusion aufgebracht wird.

14. Verfahren nach Anspruch 12, bei dem die Lackschicht durch Sprühung aufgebracht wird.

15. Verfahren nach einem der Ansprüche 11 bis 14, bei dem die Metallschicht auf der Außenseite mit einer Schutzschicht versehen wird.

16. Verfahren nach einem der Ansprüche 11 bis 15, bei dem das Kunststoffrohr nacheinander extrudiert, auf der Außenseite geglättet, in einer Reihe von Schritten in aufeinanderfolgenden Vakuumkammern mit einem kontinuierlich steigenden Vakuum auf das gewünschte Hochvakuum gebracht wird und durch physikalische Dampfablagerung unter Hochvakuum mit einer Metallschicht versehen wird.

17. Verfahren nach Anspruch 16, bei dem es, nachdem die Metallschicht aufgebracht worden ist, auf der Außenseite mittels in-line-Extrusion mit einer Schutzschicht versehen wird.

18. Verfahren nach einem der Ansprüche 11 bis 16, bei dem das Kunststoffrohr extrudiert und auf der Außenseiten geglättet wird, eine bestimmte Länge des Kunststoffrohrs aufgespult wird, in dem aufgespulten Zustand unter Hochvakuum gebracht wird und wieder abgespult wird, durch physikalische Dampfablagerung unter Hochvakuum mit einer Metallschicht versehen wird und wieder aufgespult wird.

## Revendications

1. Tuyau en matière plastique muni d'une couche barrière appliquée sur son côté extérieur, l'épaisseur de la couche barrière étant inférieure à 1 µm, **caractérisé en ce qu'**une couche intermédiaire lisse est présente entre le tuyau en matière plastique et la couche barrière.

2. Tuyau en matière plastique selon la revendication 1, dans lequel le tuyau en plastique est fabriqué à partir d'une matière thermoplastique.

3. Tuyau en matière plastique selon la revendication 1 ou 2, dans lequel la couche intermédiaire est une couche de vernis laque.

4. Tuyau en matière plastique selon l'une quelconque des revendications 1 à 3, dans lequel la couche barrière se trouvant sur le côté extérieur est munie d'une couche de protection.

5. Tuyau en matière plastique selon la revendication 4, dans lequel la couche de protection est une couche de vernis laque.

6. Tuyau en matière plastique selon la revendication 4, dans lequel la couche de protection est une couche de matière plastique.

7. Tuyau en matière plastique selon la revendication 4, dans lequel la couche de protection comporte, de l'intérieur vers l'extérieur, une couche de laque et une couche de matière plastique.

8. Tuyau en matière plastique selon la revendication 7 ou 8, dans lequel la couche de matière plastique est constituée du même matériau que le tuyau de matière plastique.

9. Tuyau en matière plastique selon l'une quelconque des revendications 1 à 8, dans lequel la couche barrière comporte une couche de métal.

10. Tuyau en matière plastique selon la revendication 9, dans lequel la couche de métal est constituée d'aluminium, d'un alliage d'aluminium ou d'oxyde d'aluminium.

11. Procédé de fabrication d'un tuyau en matière plastique ayant une couche de métal appliquée sur son côté extérieur, qui est appliquée par dépôt physique en phase vapeur sous vide poussé, le côté extérieur du tuyau en matière plastique étant lissé par l'application d'une couche de vernis laque avant que la couche de métal ne soit appliquée, dans lequel le tuyau en matière plastique est un tuyau selon la revendication 1, ladite couche de métal est la couche barrière et ladite couche de vernis laque constitue la couche intermédiaire.

12. Procédé selon la revendication 11, dans lequel la couche de vernis laque est appliquée en un process continu.

13. Procédé selon la revendication 12, dans lequel la couche de vernis laque est appliquée par extrusion.

14. Procédé selon la revendication 12, dans lequel la couche de vernis laque est appliquée par pulvérisation.

15. Procédé selon l'une quelconque des revendications 11 à 14, dans lequel la couche de métal est munie d'une couche de protection sur le côté extérieur.

16. Procédé selon l'une quelconque des revendications 11 à 15, dans lequel le tuyau en matière plastique est successivement extrudé, lissé sur le côté extérieur, amené au vide poussé souhaité en plusieurs étapes dans des chambres sous vide successives ayant un vide augmentant en continu, et muni d'une couche de métal par dépôt physique en phase vapeur sous vide poussé.

17. Procédé selon la revendication 16, dans lequel, après que la couche de métal ait été appliquée, elle est munie, sur le côté extérieur, d'une couche de protection par extrusion en ligne.

18. Procédé selon l'une quelconque des revendications 11 à 16, dans lequel le tuyau en matière plastique est extrudé et est lissé sur le côté extérieur, une certaine longueur de tuyau en matière plastique est enroulée, est placée sous vide poussé dans l'état enroulé et est à nouveau déroulée, est munie d'une couche de métal par dépôt physique en phase vapeur sous vide poussé et est enroulée à nouveau.
